# EUROPÄISCHE PATENTSCHRIFT

(11) **EP 1 368 834 B1**
(45) Veröffentlichungstag und Bekanntmachung des Hinweises auf die Patenterteilung: **10.12.2008**
(21) Anmeldenummer: 02714017.7
(22) Anmeldetag: 15.02.2002
(51) Int. Cl.: H01L 23/58

(54) **SCHALTUNG FÜR FOCUSED ION BEAM-SENSOR**
CIRCUIT FOR FOCUSED ION BEAM SENSOR
CIRCUIT POUR CAPTEUR DE FAISCEAU D'IONS FOCALISÉS

(30) Priorität: 07.03.2001 DE 10111027
(43) Veröffentlichungstag der Anmeldung: 10.12.2003
(73) Patentinhaber: Infineon Technologies AG, 81669 München (DE)
(72) Erfinder: TADDIKEN, Hans, 81737 München (DE)
(74) Vertreter: Epping - Hermann - Fischer
(86) Internationale Anmeldenummer: PCT/DE2002/000548
(87) Internationale Veröffentlichungsnummer: WO 2002/071485

(56) Entgegenhaltungen:
- WO-A-00/11719

## Beschreibung

Die vorliegende Erfindung betrifft eine Schaltung für einen FIB-Sensor, der insbesondere zum Schutz von Chipkarten-ICs eingesetzt werden kann.

Bei elektronischen Schaltungen, vor allem bei Schaltungen, die mit einem Speicher zur Aufnahme personenbezogener Information versehen sind, tritt das Problem auf, dass die Schaltung gegen eine unbefugt Analyse, insbesondere gegen ein Ausspionieren der gespeicherten Daten, geschützt werden muss. Ein möglicher Angriff kann durch FIB (Focused Ion Beam) erfolgen. Ein solcher Angriff kann mit einer dafür geeigneten Schaltung detektiert werden, so dass im Fall eines festgestellten Angriffs geeignete Gegenmaßnahmen eingeleitet werden können. Es kann z. B. dafür gesorgt werden, dass bei oder nach einem derartigen Angriff die elektronische Schaltung soweit unbrauchbar gemacht wird, dass kein unbefugtes Auslesen von Information mehr erfolgen kann.

Eine dafür geeignete Schutzschaltung stellt im Wesentlichen einen FIB-Sensor dar, der eine durch den Angriff erfolgte elektrische Aufladung der Schutzschaltung oder eines dafür vorgesehenen Schaltungsteils detektiert. Die Ladung, die als Ergebnis des FIB-Angriffs von dem FIB-Sensor detektiert wird, führt zu einer detektierbaren Veränderung des Ladungsinhalts, um erkennbar zu machen, dass die Schaltung Ziel eines FIB-Angriffs war. Der FIB-Sensor umfasst daher eine Speicherzelle mit einer Ansteuerschaltung sowie eine mit der Speicherzelle verbundene Antenne als elektrischen Leiter, auf dem bei einem FIB-Angriff elektrische Ladungen angesammmelt werden.

Die Ladung wird der Speicherzelle so zugeführt, dass die Speicherzelle eine detektierbare Veränderung ihres Ladungsinhalts erfährt. Ein weiterer Schaltungsteil ist als Ansteuerschaltung dafür vorgesehen, den Zustand der Speicherzelle des FIB-Sensors festzustellen. Es muss dabei sichergestellt werden, dass dieser Schaltungsteil so angeschlossen ist oder angeschlossen werden kann, dass die von der Antenne im Fall eines FIB-Angriffs gesammelte Ladung nicht durch die Ansteuerschaltung abfließt, bevor die Umprogrammierung der Speicherzelle stattfindet.

In der EP 0 510 434 A2 ist eine Schaltungsanordnung zur Verhinderung einer Analyse eines Schaltkreises beschrieben, bei der eine PIN-Fotodiode zur Detektion auftreffender Strahlung vorgesehen und zwischen den invertierenden und den nichtinvertierenden Eingang eines Operationsverstärkers geschaltet ist, dessen Ausgang einen Schalter steuert, der einen zu schützenden flüchtigen RAM-Speicher bei Bestrahlung von der Spannungsversorgung abschaltet.

In der WO-A-0011719 ist eine elektronische Schaltung beschrieben, die eine Speicherzelle mit einer Elektrode, einer Ansteuerschaltung und einer Antenne zur Detektion eines Angriffs umfasst, wobei die Antenne leitend mit der Elektrode verbunden ist und zwischen der Elektrode und der Ansteuerschaltung eine Kapazität vorhanden ist, die die Ansteuerschaltung von der Antenne trennt.

Aufgabe der vorliegenden Erfindung ist es, eine für einen FIB-Sensor geeignete Schaltung anzugeben, die mit Standardkomponenten eines Chipkarten-ICs realisiert werden kann.

Diese Aufgabe wird mit der Schaltung zur Detektion eines Angriffs durch FIB mit den Merkmalen des Anspruches 1 gelöst. Ausgestaltungen ergeben sich aus den abhängigen Ansprüchen.

Die erfindungsgemäße Schaltung zur Detektion eines FIB-Angriffs unter ausschließlicher Verwendung von Standardkomponenten ermöglicht die Ansteuerung der Speicherzelle (Löschen, Programmieren und Lesen) kapazitiv über eine zusätzlich vorhandene Kapazität, die die Antenne von der Ansteuerschaltung der Speicherzelle trennt. Im Fall der Detektion eines Angriffs über die Antenne wird durch die Kapazität ein Abfließen der Ladung verhindert, so dass die erzeugte Spannung auf die Speicherzelle wirkt, die dadurch eine detektierbare Veränderung ihres Ladungszustandes erfährt, zum Beispiel entsprechend umprogrammiert wird. Die Kapazität lässt sich als eine im Prinzip beliebige Kondensatorstruktur der Schaltung in an sich bekannter Weise realisieren.

Die Ausgestaltung der Speicherzelle ist im Prinzip beliebig. Vorzugsweise handelt es sich um eine an sich bekannte Floating-Gate-Zelle, EEPROM-Zelle (electrically erasable programmable read only memory) oder Flash-Zelle. Die Speicherzelle kann in einem einfachen Fall durch eine elektrisch leitende Elektrode über einer Siliziumfläche gebildet sein, wobei die Elektrode von dem Silizium durch einen Isolator getrennt ist, der als Speichermedium dient. Die Elektrode ist leitend mit der Antenne verbunden. Der Isolator kann insbesondere eine Nitridschicht umfassen. Die Struktur kann so als SONOS-Zelle (Silizium-Oxid-Nitrid-Oxid-[Poly-] Silizium) ausgebildet sein.

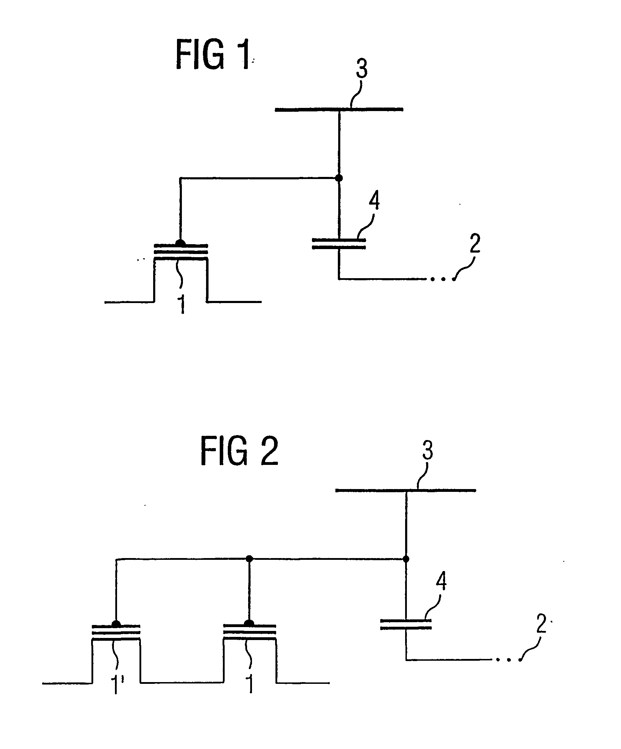

In der beigefügten Figur 2 ist ein Beispiel für die erfindungsgemäße Schaltung im Schema dargestellt.

Der prinzipielle Aufbau einer Schaltung ist in der beigefügten Figur 1 als Beispiel dargestellt, das nicht zur Erfindung gehört. Die Speicherzelle 1 des FIB-Sensors wird mit einer Ansteuerschaltung 2 betrieben, die an sich bekannt und daher nicht im Einzelnen dargestellt ist. Ein FIB-Angriff führt zu einer Aufladung von elektrischen Leitern. Die Ladung wird vorwiegend auf einer dafür vorgesehenen Antenne 3 angesammelt und zu der Speicherzelle geleitet. Erfindungsgemäß ist die Kapazität 4 dafür vorgesehen, die Ansteuerschaltung 2 von der Speicherzelle 1 und dem Schaltungszweig der Antenne 3 abzukoppeln.

In der Figur 2 ist ein demgegenüber bevorzugtes Ausführungsbeispiel der Erfindung dargestellt, bei dem eine zweite Speicherzelle 1' vorhanden ist, die ebenfalls mit der Antenne 3 verbunden und von der Ansteuerschaltung 2 durch die Kapazität 4 abgekoppelt ist. Eine Speicherzelle ist hier so ausgebildet, dass sie positive Ladungen detektiert, und die andere Speicherzelle ist so ausgebildet, dass sie negative Ladungen detektiert. Der Vorteil hierbei ist, dass Ladungen beiden Vorzeichens detektiert werden und nicht durch besondere Maßnahmen kompensiert werden können.

Die erfindungsgemäße Schaltung ist insbesondere zum Betrieb eines FIB-Sensors geeignet, der zur Absicherung eines Chipkarten-ICs vorgesehen ist.

### Bezugszeichenliste

- 1: Speicherzelle
- 1': Speicherzelle
- 2: Ansteuerschaltung
- 3: Antenne
- 4: Kapazität

## Patentansprüche

1. Schaltung zur Detektion eines Angriffs durch focused ion beam, bei der
- eine Speicherzelle (1) mit einer Elektrode, eine Ansteuerschaltung (2) und eine Antenne (3) zur Detektion des Angriffs vorhanden sind,
- die Elektrode leitend mit der Antenne (3) verbunden ist und
- zwischen der Elektrode und der Ansteuerschaltung (2) eine Kapazität (4) vorhanden ist, die die Ansteuerschaltung von der Antenne (3) trennt,
**dadurch gekennzeichnet, dass**
- zwei Speicherzellen (1, 1') vorhanden sind, die mit der Antenne (3) verbunden und von der Ansteuerschaltung (2) durch eine Kapazität (4) getrennt sind, wobei eine Speicherzelle zur Detektion positiver Ladungen ausgebildet ist, und die andere Speicherzelle zur Detektion negativer Ladungen ausgebildet ist.

2. Schaltung nach Anspruch 1, bei der
die Speicherzellen (1, 1') Speicherzellen aus der Gruppe von Floating-Gate-Zelle, EEPROM-Zelle, Flash-Zelle und SONOS-Zelle sind.

3. Schaltung nach Anspruch 1, bei der
die Speicherzellen (1, 1') eine elektrisch leitende Elektrode über einer Siliziumfläche umfassen und die Elektrode von dem Silizium durch einen Isolator getrennt ist, der als Speichermedium dient.

4. Schaltung nach einem der Ansprüche 1 bis 3 zum Betrieb eines focused ion beam Sensors eines Chipkarten-ICs.

## Claims

1. Circuit for detecting an attack by focused ion beam, in which
- there are a memory cell (1) with an electrode, a drive circuit (2) and an antenna (3) for the detection of the attack,
- the electrode is connected conductively to the antenna (3) and
- a capacitance (4) is present between the electrode and the drive circuit (2) and isolates the drive circuit from the antenna (3),
**characterized in that**
- there are two memory cells (1, 1'), which are connected to the antenna (3) and isolated from the drive circuit (2) by a capacitance (4), one memory cell being designed for the detection of positive charges and the other memory cell being designed for the detection of negative charges.

2. Circuit according to Claim 1, in which
the memory cells (1, 1') are memory cells from the group of floating gate cell, EEPROM cell, flash cell and SONOS cell.

3. Circuit according to Claim 1, in which
the memory cells (1, 1') comprise an electrically conductive electrode over a silicon area and the electrode is isolated from the silicon by an insulator which serves as storage medium.

4. Circuit according to one of Claims 1 to 3 for the operation of a focused ion beam sensor of a smart card IC.

## Revendications

1. Circuit de détection d'une attaque par focused ion beam dans lequel,
- il est prévu une cellule (1) de mémoire ayant une électrode, un circuit (2) de commande et une antenne de détection de l'attaque,
- l'électrode est reliée de manière conductrice à l'antenne (3) et,
- il y a entre l'électrode et le circuit (2) de commande d'une capacité (4) qui sépare le circuit de commande de l'antenne (3),
**caractérisé en ce que**,
il y a deux cellules (1, 1') de mémoire, qui sont reliées à l'antenne (3) et qui sont séparées du circuit (2) de commande par une capacité (4), une cellule de mémoire étant constituée pour la détection de charges positives et l'autre cellule de mémoire pour la détection de charges négatives.

2. Circuit suivant la revendication 1, dans lequel
Les cellules (1, 1') de mémoire sont des cellules de mémoire choisies dans le groupe d'une cellule à grille flottantes d'une cellule EEPROM, d'une cellule flash et d'une cellule SONOS.

3. Circuit suivant la revendication 1, dans lequel les cellules (1, 1') de mémoire ont une électrode conductrice de l'électricité sur une surface de silicium et l'électrode est séparée du silicium par un isolant qui sert de support de mémoire.

4. Circuit suivant l'une des revendications 1 et 3, pour faire fonctionner un capteur focused ion beam d'un CI de carte à puce.
